(19) Europäisches Patentamt
European Patent Office
Office européen des brevets

(11) **EP 4 197 779 A1**

(12) **EUROPEAN PATENT APPLICATION**
published in accordance with Art. 153(4) EPC

(43) Date of publication:
**21.06.2023 Bulletin 2023/25**

(21) Application number: **21855888.0**

(22) Date of filing: **30.07.2021**

(51) International Patent Classification (IPC):
*B32B 9/00* (2006.01)        *B32B 27/34* (2006.01)
*H01L 21/02* (2006.01)        *B29C 65/48* (2006.01)

(52) Cooperative Patent Classification (CPC):
**B29C 65/48; B32B 9/00; B32B 27/34; H01L 21/02**

(86) International application number:
**PCT/JP2021/028448**

(87) International publication number:
**WO 2022/034809 (17.02.2022 Gazette 2022/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **11.08.2020 JP 2020135726**

(71) Applicant: TOYOBO CO., LTD.
**Osaka-shi
Osaka 5300001 (JP)**

(72) Inventors:
• **OKUYAMA, Tetsuo**
  **Otsu-shi, Shiga 520-0292 (JP)**
• **OUYA, Kazuyuki**
  **Otsu-shi, Shiga 520-0292 (JP)**
• **TOKUDA, Kaya**
  **Otsu-shi, Shiga 520-0292 (JP)**

(74) Representative: **Vossius & Partner
Patentanwälte Rechtsanwälte mbB
Siebertstraße 3
81675 München (DE)**

(54) **LAMINATE, METHOD FOR MANUFACTURING LAMINATE, AND METHOD FOR MANUFACTURING FLEXIBLE ELECTRONIC DEVICE**

(57)    Provided is a laminate that is useful as a temporary support for producing a large-area, high-definition, flexible electronic device, the laminate having stably low adhesive strength between a heat-resistant polymer film and an inorganic substrate even in the case of a large surface area, and having few blister defects. This laminate has an inorganic substrate, a silane coupling agent layer that includes amino groups, and a heat-resistant polymer film in the stated order, the laminate being characterized in that the elemental nitrogen component ratio in an inorganic-substrate-side peel surface after the heat-resistant polymer film has been peeled from the inorganic substrate at 90° is greater than 3.5 at% and no greater than 11 at%.

**Description**

TECHNICAL FIELD

The present invention relates to a laminate, a method for manufacturing a laminate, and a method for manufacturing a flexible electronic device.

BACKGROUND ART

In recent years, for the purpose of decreasing the weight, size, and thickness of and imparting flexibility to functional elements such as semiconductor elements, MEMS elements, and display elements, technological development for forming these elements on polymer films has been actively carried out. In other words, as materials for substrates of electronic parts such as information and communication equipment (broadcasting equipment, mobile radio, portable communication equipment, and the like), radar, and high-speed information processing equipment, ceramics which exhibit heat resistance and can cope with increases in frequencies (reaching the GHz band) of the signal band of information and communication equipment have been conventionally used. However, ceramics are not flexible and are also hardly thinned and thus have a drawback that the applicable fields are limited, and polymer films have recently been used as substrates.

When functional elements such as semiconductor elements, MEMS elements, and display elements are formed on the surface of polymer films, it is ideal to perform processing by a so-called roll-to-roll process which utilizes the flexibility that is a property of polymer films. However, in industries such as semiconductor industry, MEMS industry, and display industry, process technologies for rigid flat substrates such as wafer bases or glass substrate bases have been so far constructed. Hence, in order to form functional elements on polymer films utilizing the existing infrastructure, a process is used in which the polymer films are bonded to, for example, rigid supports (inorganic substrates) formed of inorganic materials such as glass plates, ceramic plates, silicon wafers, and metal plates, desired elements are formed on the laminates, and then the polymer films and desired elements are peeled off from the supports.

However, in the process of forming a desired functional element on a laminate in which a polymer film and a support made of an inorganic substance are bonded to each other, the laminate is often exposed to a high temperature. For example, in the formation of functional elements such as polysilicon and oxide semiconductors, a step performed in a temperature region of about 200°C to 600°C is required. In addition, a temperature of about 200°C to 300°C may be applied to the film when a hydrogenated amorphous silicon thin film is fabricated, and heating at about 450°C to 600°C may be required in order to heat and dehydrogenate amorphous silicon and obtain low-temperature polysilicon. Hence, the polymer film composing the laminate is required to exhibit heat resistance, but as a practical matter, polymer films which can withstand practical use in such a high temperature region are limited. In addition, it is generally conceivable to use a pressure sensitive adhesive or an adhesive to bond a polymer film to a support, but heat resistance is also required for the joint surface (namely, the adhesive or pressure sensitive adhesive for bonding) between the polymer film and the support at that time. However, since ordinary adhesives and pressure sensitive adhesives for bonding do not exhibit sufficient heat resistance, bonding with an adhesive or a pressure sensitive adhesive cannot be adopted when the formation temperature of functional element is high.

Since there are no pressure sensitive adhesives or adhesives exhibiting sufficient heat resistance, a technology in which a polymer solution or a polymer precursor solution is applied onto an inorganic substrate, dried and cured on the inorganic substrate to be formed into a film, and used for these applications has been conventionally adopted in the above-mentioned applications. However, the polymer film obtained by such means is brittle and easily torn and thus the functional element formed on the surface of this polymer film is often destroyed when being peeled off from the inorganic substrate. In particular, it is extremely difficult to peel off a large-area film from an inorganic substrate, and it is not possible to attain an industrially viable yield.

In view of such circumstances, a laminate in which a polyimide film, which exhibits excellent heat resistance, is tough, and can be thinned, is bonded to an inorganic substrate with a silane coupling agent interposed therebetween has been proposed as a laminate of a polymer film and an inorganic substrate for manufacturing a so-called flexible electronic device in which a functional element is formed on a flexible substrate (for example, see Patent Documents 1 to 3).

PRIOR ART DOCUMENTS

PATENT DOCUMENTS

Patent Document 1: JP-B-5152104
Patent Document 2: JP-B-5304490
Patent Document 3: JP-B-5531781

SUMMARY OF THE INVENTION

PROBLEMS TO BE SOLVED BY THE INVENTION

In the above-described laminate, it is intended that the inorganic substrate is easily peeled off from the polyimide film after device formation as well as the inorganic substrate is prevented from peeling off from the polyimide film before and during device formation by interposing a layer containing a silane coupling agent between the inorganic substrate and the heat resistant polymer film.

However, since the adhesive force between the polymer film and the inorganic substrate varies depending on the thickness of the silane coupling agent, it is extremely difficult to control the adhesive force of both companies with uniform adhesive strength over a large area. In other words, it is difficult to coat a silane coupling agent on a large substrate so as to have a uniform thickness. Particularly in a glass substrate having a size of 730 mm × 920 mm or more, which is called the 4.5th generation, the degree of difficulty is extremely higher compared to the 4th generation (660 mm × 800 mm) size, and there are a large number of problems in industrial production.

MEANS FOR SOLVING THE PROBLEMS

In view of this situation, the present inventors have continuously conducted diligent studies, and as a result, found out a manufacturing method by which it is possible to easily control the thickness of a silane coupling agent to be extremely thin and uniform in a large area exceeding the 4.5th generation size as well, and to obtain a high-quality laminate having a small number of blister defects. It has also been found out that a laminate in which a heat resistant polymer film and an inorganic substrate are laminated by an extremely homogeneous and extremely thin silane coupling agent layer is realized by the manufacturing method of the present invention, and a high-quality flexible electronic device can be manufactured by using this laminate.

In other words, the present invention has the following configurations.

[1] A laminate including an inorganic substrate, a layer of a silane coupling agent containing an amino group, and a heat resistant polymer film in this order, in which an elemental nitrogen component ratio on a peeled surface on an inorganic substrate side is more than 3.5 at% and 11 at% or less after the heat resistant polymer film has been peeled off from the inorganic substrate at 90°.

[2] The laminate according to [1], in which an adhesive strength by a 90° peeling method when the heat resistant polymer film is peeled off from the laminate is 0.06 N/cm or more and 0.25 N/cm or less.

[3] The laminate according to [1] or [2], in which a surface roughness Ra of the inorganic substrate is 1 nm or more and 1000 nm or less.

[4] The laminate according to any one of [1] to [3], in which the heat resistant polymer film is a polyimide film.

[5] The laminate according to any one of [1] to [4], in which a blister defect density is 5 spots or less per 1 square meter.

[6] The laminate according to any one of [1] to [5], in which the heat resistant polymer film is rectangular, has an area of 0.65 square meter or more, and has a rectangular side of at least 700 mm or more.

[7] A method for manufacturing a laminate including an inorganic substrate, a layer of a silane coupling agent containing an amino group, and a heat resistant polymer film in this order, the method including at least:

(1) a step of coating at least one surface of an inorganic substrate with a silane coupling agent containing an amino group;
(2) a step of supplying an aqueous medium to a silane coupling agent-coated surface of the inorganic substrate and/or a bonding surface side of a heat resistant polymer film;
(3) a step of stacking the silane coupling agent-coated surface of the inorganic substrate and the heat resistant polymer film; and
(4) a step of pressurizing the inorganic substrate and the heat resistant polymer film while extruding the aqueous medium from between the silane coupling agent-coated surface of the inorganic substrate and the bonding surface of the heat resistant polymer film.

[8] A method for manufacturing a laminate including an inorganic substrate, a layer of a silane coupling agent containing an amino group, and a heat resistant polymer film in this order, the method including at least:

(1) a step of coating at least one surface of a heat resistant polymer film with a silane coupling agent containing an amino group;

(2) a step of supplying an aqueous medium to a bonding surface side of an inorganic substrate and/or a silane coupling agent-coated surface of the heat resistant polymer film;

(3) a step of stacking the inorganic substrate and the silane coupling agent-coated surface of the heat resistant polymer film; and

(4) a step of pressurizing the inorganic substrate and the heat resistant polymer film while extruding the aqueous medium from between the bonding surface of the inorganic substrate and the silane coupling agent-coated surface of the heat resistant polymer film.

[9] A method for manufacturing a flexible electronic device, the method including a step of forming a functional element on a surface on an opposite side to a bonding surface of a heat resistant polymer film with an inorganic substrate of a laminate obtained by the manufacturing steps according to [7] or [8].

EFFECT OF THE INVENTION

As described in the prior art, in a laminate of a heat resistant polymer film and an inorganic substrate mainly such as a glass plate for manufacturing a flexible electronic device, particularly when the laminate has a large area, it is difficult to homogenously coat a silane coupling agent, and as a result, it is difficult to uniformly and properly control the adhesive strength between the heat resistant polymer film and the inorganic substrate.

However, according to the present invention, it is possible to realize a large-area laminate, which is a rectangle having an area of 0.65 square meter or more and has a side of at least 700 mm or more and in which the adhesive strength can be controlled in a range of 0.06 N/cm or more and 0.25 N/cm or less and blister defects between the heat resistant polymer film and the inorganic substrate are unlikely to be generated, and to provide a method for manufacturing a flexible electronic device having a large area by using this laminate.

Hereinafter, in order to avoid complication, the heat resistant polymer film may be simply referred to as polymer film or film, and the inorganic substrate may simply be referred to as substrate. A silane coupling agent is simply an amino group-containing silane coupling agent.

The present invention is the same as the prior art in that either of a polymer film or an inorganic substrate is coated with a silane coupling agent and then the two are bonded together (laminated), but is greatly different in that an aqueous medium (for example, pure water or a mixed solvent of water and a water-soluble solvent such as lower alcohol) is interposed between the two and the two are laminated while extruding the aqueous medium from the bonding surface at the time of lamination.

By the method, the excess silane coupling agent between the inorganic substrate and the polymer film can be removed, and the amount of the silane coupling agent is controlled to the minimum necessary amount coordinated on the surface of at least either of the substrate or the film by the affinity.

It is presumed that the adhesive force between the substrate and the polymer film changes over time or after the substrate and the polymer film have undergone a high-temperature process because the reaction of the silane coupling agent, which is excessively present and unreacted, proceeds. However, such an excess unreacted substance can be eliminated from the bonding interface between the substrate and the film according to the method of the present invention.

By this method, it is possible to obtain a laminate in which the elemental nitrogen (elemental N) component ratio observed by ESCA is more than 3.5 at% and 11 at% or less on the inorganic substrate surface after the film has been peeled off. This N element reflects the presence of an amino group-containing silane coupling agent. For this reason, even in the case of substrates that do not contain Si atoms, such as SUS substrates, Cu substrates, and $Al_2O_3$ substrates, the elemental Si component ratio on the peeled surface on the inorganic substrate side is detected to be about 15 at% to 25 at% after the heat resistant polymer film has been peeled off from the inorganic substrate at 90°.

Furthermore, in this bonding method, the excess silane coupling agent is eliminated, thus foreign matters due to the condensation of the silane coupling agent are less likely to be generated, and at the same time, dust and the like coexisting on the bonding surface are also extruded, thus foreign matters having a particle size at the bonding interface drastically decrease, and as a result, the number of blister defects (also called bubbles, floats, and the like), in which these foreign matters are the nuclei, decreases.

According to the configuration, the silane coupling agent layer is thick enough to have sufficient adhesive strength, there is no excess silane coupling agent, thus the adhesive strength is not too strong, and the initial adhesive strength is in a range of 0.06 N/cm or more and 0.25 N/cm or less. This is clear from Examples as well. In this regard, the present inventors presume that since a large number of OH groups are present on the surface of the inorganic substrate at the initial stage of depositing the silane coupling agent on the inorganic substrate, as a result of binding between the OH groups and the silane coupling agent layer by a hydrogen bond, a chemical reaction and the like, a firm silane coupling agent layer is obtained. However, when the deposition time of silane coupling agent is increased, the silane coupling agent layer, which does not necessarily have a firm bond, easily enters the heat resistant polymer film, and the adhesive strength changes depending on the entering method and the binding method at the entered location.

In the configuration, it is preferable that the 90° (90-degree) initial adhesive strength between the heat resistant polymer film and the inorganic substrate is 0.06 N/cm or more and 0.25 N/cm or less.

When the 90-degree initial adhesive strength is 0.06 N/cm or more, it is possible to suitably prevent the heat resistant polymer film from peeling off from the inorganic substrate before and during device formation. When the 90-degree initial adhesive strength is 0.25 N/cm or less, the device can be peeled off without being destroyed at the time of mechanical peeling.

In the configuration, it is preferable that the blister defect density between the heat resistant polymer film and the inorganic substrate is 5 spots or less per 1 square meter.

It is preferable that the surface roughness Ra of the inorganic substrate is 1 nm or more and 1000 nm or less.

In the configuration, it is preferable that the number of bubbles between the heat resistant polymer film and the inorganic substrate is 1 or less per 500 mm × 500 mm.

When the number of bubbles is 1 or less per 500 mm × 500 mm, it is possible to remarkably decrease the possibility that the device is destroyed by the growth of bubbles when the device is fabricated on the heat resistant polymer film.

BRIEF DESCRIPTION OF THE DRAWING

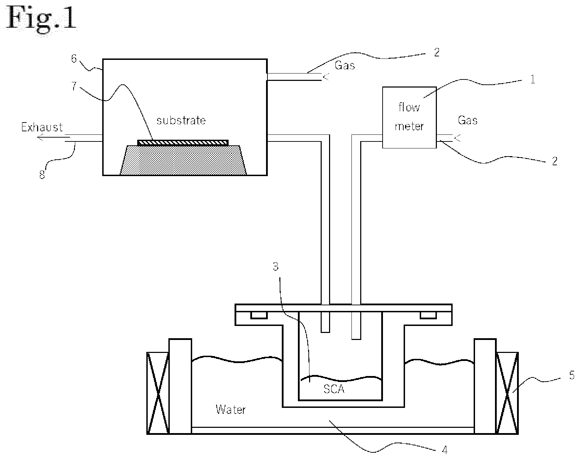

Fig. 1 is a schematic diagram of an apparatus for coating an inorganic substrate with a silane coupling agent.

MODE FOR CARRYING OUT THE INVENTION

In the present specification, the heat resistant polymer is a polymer having a melting point of preferably 400°C or more, more preferably 500°C or more and a glass transition temperature of preferably 250°C or more, more preferably 320°C or more, still more preferably 380°C or more. Hereinafter, the heat resistant polymer is also simply referred to as a polymer in order to avoid complication. In the present specification, the melting point and the glass transition temperature are determined by differential thermal analysis (DSC). Incidentally, in a case where the melting point exceeds 500°C, it may be judged whether or not the temperature has reached the melting point by visually observing the thermal deformation behavior when the heat resistant polymer is heated at this temperature.

Examples of the heat resistant polymer film (hereinafter, also simply referred to as a polymer film) includes films of polyimide-based resins (for example, aromatic polyimide resin and alicyclic polyimide resin) such as polyimide, polyamide-imide, polyetherimide, and fluorinated polyimide; copolymerized polyesters (for example, fully aromatic polyesters and semi-aromatic polyesters) such as polyethylene, polypropylene, polyethylene terephthalate, polybutylene terephthalate, and polyethylene-2,6-naphthalate; copolymerized (meth)acrylates represented by polymethylmethacrylate; polycarbonates; polyamides; polysulfones; polyethersulfones; polyetherketones; cellulose acetates; cellulose nitrates; aromatic polyamides; polyvinyl chloride; polyphenols; polyarylates; polyphenylene sulfides; polyphenylene oxides; and polystyrenes.

However, since the polymer film is premised on being used in a process involving heat treatment at 450°C or more, those that can actually be adopted among the exemplified polymer films are limited. Among the polymer films, a film obtained using a so-called super engineering plastic is preferable, and more specific examples include an aromatic polyimide film, an aromatic amide film, an aromatic amideimide film, an aromatic benzoxazole film, an aromatic benzothiazole film, and an aromatic benzimidazole film.

The details of the polyimide-based resin film (referred to as a polyimide film in some cases) which is an example of the polymer film will be described below. Generally, the polyimide-based resin film is obtained by applying a polyamic acid (polyimide precursor) solution which is obtained by a reaction between a diamine and a tetracarboxylic acid in a solvent, to a support for polyimide film fabrication, drying the solution to form a green film (hereinafter, also called as a "polyamic acid film"), and treating the green film by heat at a high temperature to cause a dehydration ring-closure reaction on the support for polyimide film fabrication or in a state of being peeled off from the support.

For the application of the polyamic acid (polyimide precursor) solution, it is possible to appropriately use, for example, conventionally known solution application means such as spin coating, doctor blade, applicator, comma coater, screen printing method, slit coating, reverse coating, dip coating, curtain coating, and slit die coating.

The diamines constituting the polyamic acid are not particularly limited, and aromatic diamines, aliphatic diamines, alicyclic diamines and the like which are usually used for polyimide synthesis can be used. From the viewpoint of the heat resistance, aromatic diamines are preferable, and among the aromatic diamines, aromatic diamines having a benzoxazole structure are more preferable. When aromatic diamines having a benzoxazole structure are used, a high elastic modulus, low heat shrinkability, and a low coefficient of linear thermal expansion as well as the high heat resistance can be exerted. The diamines can be used singly or in combination of two or more kinds thereof.

The aromatic diamines having a benzoxazole structure are not particularly limited, and examples thereof include: 5-amino-2-(p-aminophenyl)benzoxazole; 6-amino-2-(p-aminophenyl)benzoxazole; 5-amino-2-(m-aminophenyl)benzoxazole; 6-amino-2-(m-aminophenyl)benzoxazole; 2,2'-p-phenylenebis(5-aminobenzoxazole); 2,2'-p-phenylenebis(6-aminobenzoxazole); 1-(5-aminobenzoxazolo)-4-(6-aminobenzoxazolo)benzene; 2,6-(4,4'-diaminodiphenyl)benzo[1,2-d:5,4-d']bisoxazole; 2,6-(4,4'-diaminodiphenyl)benzo[1,2-d:4,5-d']bisoxazole; 2,6-(3,4'-diaminodiphenyl)benzo[1,2-d:5,4-d']bisoxazole; 2,6-(3,4'-diaminodiphenyl)benzo[1,2-d:4,5-d']bisoxazole; 2,6-(3,3'-diaminodiphenyl)benzo[1,2-d:5,4-d']bisoxazole; and 2,6-(3,3'-diaminodiphenyl)benzo[1,2-d:4,5-d']bisoxazole.

Examples of the aromatic diamines other than the above-described aromatic diamines having benzoxazole structures include: 2,2'-dimethyl-4,4'-diaminobiphenyl; 1,4-bis[2-(4-aminophenyl)-2-propyl]benzene(bisaniline); 1,4-bis(4-amino-2-trifluoromethylphenoxy)benzene; 2,2'-ditrifluoromethyl-4,4'-diaminobiphenyl; 4,4'-bis(4-aminophenoxy)biphenyl; 4,4'-bis(3-aminophenoxy)biphenyl; bis[4-(3-aminophenoxy)phenyl]ketone; bis[4-(3-aminophenoxy)phenyl]sulfide; bis[4-(3-aminophenoxy)phenyl]sulfone; 2,2-bis[4-(3-aminophenoxy)phenyl]propane; 2,2-bis[4-(3-aminophenoxy)phenyl]-1,1,1,3,3,3-hexafluoropropane; m-phenylenediamine; o-phenylenediamine; p-phenylenediamine; m-aminobenzylamine; p-aminobenzylamine; 3,3'-diaminodiphenylether; 3,4'-diaminodiphenylether; 4,4'-diaminodiphenylether; 3,3'-diaminodiphenylsulfide; 3,3'-diaminodiphenylsulfoxide; 3,4'-diaminodiphenylsulfoxide; 4,4'-diaminodiphenylsulfoxide; 3,3'-diaminodiphenylsulfone; 3,4'-diaminodiphenylsulfone; 4,4'-diaminodiphenylsulfone; 3,3'-diaminobenzophenone; 3,4'-diaminobenzophenone; 4,4'-diaminobenzophenone; 3,3'-diaminodiphenylmethane; 3,4'-diaminodiphenylmethane; 4,4'-diaminodiphenylmethane; bis[4-(4-aminophenoxy)phenyl]methane; 1,1-bis[4-(4-aminophenoxy)phenyl]ethane; 1,2-bis[4-(4-aminophenoxy)phenyl]ethane; 1,1-bis[4-(4-aminophenoxy)phenyl]propane; 1,2-bis[4-(4-aminophenoxy)phenyl]propane; 1,3-bis[4-(4-aminophenoxy)phenyl]propane; 2,2-bis[4-(4-aminophenoxy)phenyl]propane; 1,1-bis[4-(4-aminophenoxy)phenyl]butane; 1,3-bis[4-(4-aminophenoxy)phenyl]butane; 1,4-bis[4-(4-aminophenoxy)phenyl]butane; 2,2-bis[4-(4-aminophenoxy)phenyl]butane; 2,3-bis[4-(4-aminophenoxy)phenyl]butane; 2-[4-(4-aminophenoxy)phenyl]-2-[4-(4-aminophenoxy)-3-methylphenyl]propane; 2,2-bis[4-(4-aminophenoxy)-3-methylphenyl]propane; 2-[4-(4-aminophenoxy)phenyl]-2-[4-(4-aminophenoxy)-3,5-dimethylphenyl]propane; 2,2-bis[4-(4-aminophenoxy)-3,5-dimethylphenyl]propane; 2,2-bis[4-(4-aminophenoxy)phenyl]-1,1,1,3,3,3-hexafluoropropane; 1,4-bis(3-aminophenoxy)benzene; 1,3-bis(3-aminophenoxy)benzene; 1,4-bis(4-aminophenoxy)benzene; 4,4'-bis(4-aminophenoxy)biphenyl; bis[4-(4-aminophenoxy)phenyl]ketone; bis[4-(4-aminophenoxy)phenyl]sulfide; bis[4-(4-aminophenoxy)phenyl]sulfoxide; bis[4-(4-aminophenoxy)phenyl]sulfone; bis[4-(3-aminophenoxy)phenyl]ether; bis[4-(4-aminophenoxy)phenyl]ether; 1,3-bis[4-(4-aminophenoxy)benzoyl]benzene; 1,3-bis[4-(3-aminophenoxy)benzoyl]benzene; 1,4-bis[4-(3-aminophenoxy)benzoyl]benzene; 4,4'-bis[(3-aminophenoxy)benzoyl]benzene; 1,1-bis[4-(3-aminophenoxy)phenyl]propane; 1,3-bis[4-(3-aminophenoxy)phenyl]propane; 3,4'-diaminodiphenylsulfide; 2,2-bis[3-(3-aminophenoxy)phenyl]-1,1,1,3,3,3-hexafluoropropane; bis[4-(3-aminophenoxy)phenyl]methane; 1,1-bis[4-(3-aminophenoxy)phenyl]ethane; 1,2-bis[4-(3-aminophenoxy)phenyl]ethane; bis[4-(3-aminophenoxy)phenyl]sulfoxide; 4,4'-bis[3-(4-aminophenoxy)benzoyl]diphenylether; 4,4'-bis[3-(3-aminophenoxy)benzoyl]diphenylether; 4,4'-bis[4-(4-amino-$\alpha,\alpha$-dimethylbenzyl)phenoxy]benzophenone; 4,4'-bis[4-(4-amino-$\alpha,\alpha$-dimethylbenzyl)phenoxy]diphenylsulfone; bis[4-{4-(4-aminophenoxy)phenoxy}phenyl]sulfone; 1,4-bis[4-(4-aminophenoxy)phenoxy-$\alpha,\alpha$-dimethylbenzyl]benzene; 1,3-bis[4-(4-aminophenoxy)phenoxy-$\alpha,\alpha$-dimethylbenzyl]benzene; 1,3-bis[4-(4-amino-6-trifluoromethylphenoxy)-$\alpha,\alpha$-dimethylbenzyl]benzene; 1,3-bis[4-(4-amino-6-fluorophenoxy)-$\alpha,\alpha$-dimethylbenzyl]benzene; 1,3-bis[4-(4-amino-6-methylphenoxy)-$\alpha,\alpha$-dimethylbenzyl]benzene; 1,3-bis[4-(4-amino-6-cyanophenoxy)-$\alpha,\alpha$-dimethylbenzyl]benzene; 3,3'-diamino-4,4'-diphenoxybenzophenone; 4,4'-diamino-5,5'-diphenoxybenzophenone; 3,4'-diamino-4,5'-diphenoxybenzophenone; 3,3'-diamino-4-phenoxybenzophenone; 4,4'-diamino-5-phenoxybenzophenone, 3,4'-diamino-4-phenoxybenzophenone; 3,4'-diamino-5'-phenoxybenzophenone; 3,3'-diamino-4,4'-dibiphenoxybenzophenone; 4,4'-diamino-5,5'-dibiphenoxybenzophenone; 3,4'-diamino-4,5'-dibiphenoxybenzophenone; 3,3'-diamino-4-biphenoxybenzophenone; 4,4'-diamino-5-biphenoxybenzophenone; 3,4'-diamino-4-biphenoxybenzophenone; 3,4'-diamino-5'-biphenoxybenzophenone; 1,3-bis(3-amino-4-phenoxybenzoyl)benzene; 1,4-bis(3-amino-4-phenoxybenzoyl)benzene; 1,3-bis(4-amino-5-phenoxybenzoyl)benzene; 1,4-bis(4-amino-5-phenoxybenzoyl)benzene; 1,3-bis(3-amino-4-biphenoxybenzoyl)benzene, 1,4-bis(3-amino-4-biphenoxybenzoyl)benzene; 1,3-bis(4-amino-5-biphenoxybenzoyl)benzene; 1,4-bis(4-amino-5-biphenoxybenzoyl)benzene; 2,6-bis[4-(4-amino-$\alpha,\alpha$-dimethylbenzyl)phenoxy]benzonitrile; and aromatic diamines obtained by substituting a part or all of hydrogen atoms on an aromatic ring of the above-described aromatic diamines with halogen atoms; C1-3 alkyl groups or alkoxyl groups; cyano groups; or C1-3 halogenated alkyl groups or alkoxyl groups in which a part or all of hydrogen atoms of an alkyl group or alkoxyl group are substituted with halogen atoms.

Examples of the aliphatic diamines include: 1,2-diaminoethane; 1,4-diaminobutane; 1,5-diaminopentane; 1,6-diaminohexane; and 1,8-diaminooctane.

Examples of the alicyclic diamines include: 1,4-diaminocyclohexane and 4,4-methylenebis(2,6-dimethylcyclohexylamine).

The total amount of diamines (aliphatic diamines and alicyclic diamines) other than the aromatic diamines is preferably 20% by mass or less, more preferably 10% by mass or less, still more preferably 5% by mass or less of the total amount of all the diamines. In other words, the amount of aromatic diamines is preferably 80% by mass or more, more preferably 90% by mass or more, still more preferably 95% by mass or more of the total amount of all the diamines.

As tetracarboxylic acids constituting the polyamic acid, aromatic tetracarboxylic acids (including anhydrides thereof), aliphatic tetracarboxylic acids (including anhydrides thereof) and alicyclic tetracarboxylic acids (including anhydrides thereof), which are usually used for polyimide synthesis, can be used. Among these, aromatic tetracarboxylic anhydrides and alicyclic tetracarboxylic anhydrides are preferable, aromatic tetracarboxylic anhydrides are more preferable from the viewpoint of the heat resistance, and alicyclic tetracarboxylic acids are more preferable from the viewpoint of light transmittance. In a case where these are acid anhydrides, the acid anhydrides may have one anhydride structure or two anhydride structures in the molecule, but one (dianhydride) having two anhydride structures in the molecule is preferable. The tetracarboxylic acids may be used singly or in combination of two or more kinds thereof.

Examples of the alicyclic tetracarboxylic acids include: alicyclic tetracarboxylic acids such as cyclobutanetetracarboxylic acid; 1,2,4,5-cyclohexanetetracarboxylic acid; 3,3',4,4'-bicyclohexyltetracarboxylic acid; and anhydrides thereof. Among these, dianhydrides having two anhydride structures (for example, cyclobutanetetracarboxylic dianhydride, 1,2,4,5-cyclohexanetetracarboxylic dianhydride, 3,3',4,4'-bicyclohexyltetracarboxylic dianhydride and the like) are suitable. Incidentally, the alicyclic tetracarboxylic acids may be used singly or in combination of two or more kinds thereof.

For obtaining high transparency, the amount of the alicyclic tetracarboxylic acids is, for example, preferably 80% by mass or more, more preferably 90% by mass or more, still more preferably 95% by mass or more of the total amount of all the tetracarboxylic acids.

The aromatic tetracarboxylic acids are not particularly limited, but a pyromellitic acid residue (namely, one having a structure derived from pyromellitic acid) is preferable, and an anhydride thereof is more preferable. Examples of these aromatic tetracarboxylic acids include: pyromellitic dianhydride; 3,3',4,4'-biphenyltetracarboxylic dianhydride; 4,4'-oxydiphthalic dianhydride; 3,3',4,4'-benzophenonetetracarboxylic dianhydride; 3,3',4,4'-diphenylsulfonetetracarboxylic dianhydride; and 2,2-bis[4-(3,4-dicarboxyphenoxy)phenyl]propionic anhydride.

For obtaining high heat resistance, the amount of the aromatic tetracarboxylic acids is, for example, preferably 80% by mass or more, more preferably 90% by mass or more, still more preferably 95% by mass or more of the total amount of all the tetracarboxylic acids.

The thickness of the polymer film is preferably 3 um or more, more preferably 11 $\mu$m or more, still more preferably 24 $\mu$m or more, yet still more preferably 45 um or more. The upper limit of the thickness of the polymer film is not particularly limited but is preferably 250 um or less, more preferably 150 $\mu$m or less, still more preferably 90 $\mu$m or less for use as a flexible electronic device.

The average CTE of the polymer film at between 30°C and 300°C is preferably -5 ppm/°C to +20 ppm/°C, more preferably -5 ppm/°C to +15 ppm/°C, still more preferably 1 ppm/°C to +10 ppm/°C. When the CTE is in the above range, a small difference in coefficient of linear thermal expansion between the polymer film and a general support (inorganic substrate) can be maintained, and the polymer film and the inorganic substrate can be prevented from peeling off from each other when being subjected to a process of applying heat as well. Here, CTE is a factor that represents reversible expansion and contraction with respect to temperature. The CTE of the polymer film refers to the average value of the CTE in the flow direction (MD direction) and the CTE in the width direction (TD direction) of the polymer film. The method for measuring the CTE of the polymer film is as described in Examples.

The heat shrinkage rate of the polymer film at between 30°C and 500°C is preferably $\pm$ 0.9%, still more preferably $\pm$ 0.6%. The heat shrinkage rate is a factor that represents irreversible expansion and contraction with respect to the temperature.

The tensile breaking strength of the polymer film is preferably 60 MPa or more, more preferably 120 MP or more, still more preferably 240 MPa or more. The upper limit of the tensile breaking strength is not particularly limited but is practically less than about 1000 MPa. When the tensile breaking strength is 60 MPa or more, it is possible to prevent the polymer film from breaking when being peeled off from the inorganic substrate. The tensile breaking strength of the polymer film refers to the average value of the tensile breaking strength in the machine direction (MD direction) and the tensile breaking strength in the transverse direction (TD direction) of the polymer film. The method for measuring the tensile breaking strength of the polymer film is as described in Examples.

The tensile breaking elongation of the polymer film is preferably 1% or more, more preferably 5% or more, still more preferably 20% or more. When the tensile breaking elongation is 1% or more, the handleability is excellent. The tensile breaking elongation of the polymer film refers to the average value of the tensile breaking elongation in the machine direction (MD direction) and the tensile breaking elongation in the transverse direction (TD direction) of the polymer film. The method for measuring the tensile breaking elongation of the polymer film is as described in Examples.

The tensile elasticity of the polymer film is preferably 3 GPa or more, more preferably 6 GPa or more, still more preferably 8 GPa or more. When the tensile elasticity is 3 GPa or more, the polymer film is less expanded and deformed when being peeled off from the inorganic substrate and exhibits excellent handleability. The tensile elasticity is preferably 20 GPa or less, more preferably 12 GPa or less, still more preferably 10 GPa or less. When the tensile elasticity is 20 GPa or less, the polymer film can be used as a flexible film. The tensile elasticity of the polymer film refers to the average value of the tensile elasticity in the machine direction (MD direction) and the tensile elasticity in the transverse direction (TD direction) of the polymer film. The method for measuring the tensile elasticity of the polymer film is as described in Examples.

Unevenness of the thickness of the polymer film is preferably 20% or less, more preferably 12% or less, still more preferably 7% or less, particularly preferably 4% or less. When the unevenness of the thickness exceeds 20%, the polymer film tends to be hardly applied to a narrow part. Incidentally, unevenness of the thickness of a film can be determined based on the following equation from film thicknesses, which are measured at about 10 randomly extracted points of a film to be measured by using, for example, a contact-type film thickness meter.

$$\texttt{Unevenness of thickness of film (\%)}$$
$$= 100 \times \texttt{(maximum film thickness} - \texttt{minimum film}$$
$$\texttt{thickness)} \div \texttt{average film thickness}$$

The polymer film is preferably obtained in the form of being wound as a long polymer film having a width of 300 mm or more and a length of 10 m or more at the time of production, more preferably in the form of a roll-shaped polymer film wound around a winding core. When the polymer film is wound in a roll shape, it is easy to transport the polymer film in the form of a heat resistant polymer film wound in a roll shape.

The shape of the laminate may be various shapes such as a circular square other than a rectangular shape. At the time of rectangular laminate formation, heat resistant polymer films are also rectangular in many cases, and can be applied to various sizes, from small to large, depending on the intended use. It is possible to fabricate a laminate having an area of 0.65 square meter or more and a laminate having a rectangular side of at least 700 mm or more. A more preferable area in the fabrication of a large-area device is 0.7 square meter or more, and still more preferably it is easy to fabricate a large-area device having an area of 1 square meter or more and 5 square meters or less. The lower limit is not particularly limited, and is preferably 0.01 square meter or more, more preferably 0.1 square meter or more. The length of a rectangular side is more preferably 800 mm, still more preferably 900 mm or more. The lower limit is not particularly limited, and is preferably 50 mm or more, more preferably 100 mm or more.

In order to secure handleability and productivity of the polymer film, a lubricant (particles) having a particle size of about 10 to 1000 nm is preferably added to/contained in the polymer film at about 0.03% to 3% by mass to impart fine unevenness to the surface of the polymer film and secure slipperiness.

The inorganic substrate of the present invention is only required to be a plate-shaped substrate that can be used as a substrate formed of an inorganic substance, and examples thereof include those mainly composed of glass plates, ceramic plates, semiconductor wafers, metals and the like and those in which these glass plates, ceramic plates, semiconductor wafers, and metals are laminated, those in which these are dispersed, and those in which fibers of these are contained as the composite of these.

In the present invention, an inorganic substrate, which does not contain nitrogen as a constituent element, is preferably used.

Examples of the glass plates include quartz glass, high silicate glass (96% silica), soda lime glass, lead glass, aluminoborosilicate glass, and borosilicate glass (Pyrex (registered trademark)), borosilicate glass (alkali-free), borosilicate glass (microsheet), aluminosilicate glass and the like. Among these, those having a coefficient of linear thermal expansion of 5 ppm/K or less are desirable, and in the case of a commercially available product, "Corning (registered trademark) 7059", "Corning (registered trademark) 1737", and "EAGLE" manufactured by Corning Inc., "AN100" manufactured by AGC Inc., "OA10" and "OA11" manufactured by Nippon Electric Glass Co., Ltd., "AF32" manufactured by SCHOTT AG, and the like that are glass for liquid crystals are desirable.

The semiconductor wafer is not particularly limited, but examples thereof include a silicon wafer and wafers of germanium, silicon-germanium, gallium-arsenide, aluminum-gallium-indium, nitrogen-phosphorus-arsenic-antimony, SiC, InP (indium phosphide), InGaAs, GaInNAs, LT, LN, ZnO (zinc oxide), CdTe (cadmium telluride), ZnSe (zinc selenide) and the like. Among these, the wafer preferably used is a silicon wafer, and a mirror-polished silicon wafer having a size of 8 inches or more is particularly preferable.

The metals include single element metals such as W, Mo, Pt, Fe, Ni, and Au, alloys such as Inconel, Monel, Nimonic, carbon-copper, Fe-Ni-based Invar alloy, and Super Invar alloy, and steel (carbon steel). The metals also include multi-layered metal plates obtained by adding other metal layers and ceramic layers to these metals. In this case, when the overall coefficient of linear thermal expansion (CTE) with the additional layer is low, Cu, Al and the like are also used in the main metal layer. The metals used as the addition metal layer is not limited as long as they are those that strengthen the close contact property with the polymer film, those that have properties that there is no diffusion and the chemical resistance and heat resistance are favorable, but suitable examples thereof include Cr, Ni, TiN, and Mo-containing Cu.

It is required that the flat portion of the inorganic substrate is flat to some extent. The surface roughness Ra of part or whole of the surface of the inorganic substrate is preferably 1 nm or more, more desirably 3 nm or more and is preferably 1000 nm or less, more desirably 600 nm or less, still more desirably 100 nm or less. When the surface roughness is within the above range, it is possible to stably bond the inorganic substrate with the polymer film. When the surface is coarser than this, the adhesive strength between the polymer film layer and the inorganic substrate may be insufficient. The surface roughness Ra of the inorganic substrate is the value before the inorganic substrate is bonded with the polymer film.

The thickness of the inorganic substrate is not particularly limited, but a thickness of 10 mm or less is preferable, a thickness of 3 mm or less is more preferable, and a thickness of 1.3 mm or less is still more preferable from the viewpoint of handleability. The lower limit of the thickness is not particularly limited, but is preferably 0.05 mm or more, more preferably 0.3 mm or more, still more preferably 0.5 mm or more.

The silane coupling agent (SCA) of the present invention has an action of bonding the inorganic substrate and the polymer film to each other by being physically or chemically interposed between the inorganic substrate and the metal-containing layer.

The silane coupling agent used in the present invention includes a coupling agent having at least an amino group.

Preferred specific examples of the silane coupling agent include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, N-(vinylbenzyl)-2-aminoethyl-3-aminopropyltrimethoxysilane hydrochloride, aminophenyltrimethoxysilane, aminophenethyltrimethoxysilane, and aminophenylaminomethylphenethyltrimethoxysilane.

Among the silane coupling agents, a silane coupling agent having one silicon atom in one molecule is particularly preferable, and examples thereof include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, aminophenyltrimethoxysilane, aminophenethyltrimethoxysilane, and aminophenylaminomethylphenethyltrimethoxysilane. When particularly high heat resistance is required in the process, a silane coupling agent, in which an aromatic group links Si and an amino group to each other via, is desirable.

In addition to the above, 11-amino-1-undecenethiol can also be used as the coupling agent.

As the method for forming a silane coupling agent layer, a method in which a silane coupling agent solution is applied to the inorganic substrate, a vapor deposition method, and the like can be used. The silane coupling agent layer may be formed on the surface of the heat resistant polymer.

As the method for applying a silane coupling agent solution, it is possible to use a solution of a silane coupling agent diluted with a solvent such as an alcohol and to appropriately use conventionally known solution application means such as a spin coating method, a curtain coating method, a dip coating method, a slit die coating method, a gravure coating method, a bar coating method, a comma coating method, an applicator method, a screen printing method, and a spray coating method.

The silane coupling agent layer can also be formed by a vapor deposition method, and is specifically formed by exposing the inorganic substrate to the vapor of a silane coupling agent, namely, a silane coupling agent in a substantially gaseous state. The vapor of a silane coupling agent can be obtained by heating the silane coupling agent in a liquid state at a temperature of 40°C to about the boiling point of the silane coupling agent. The boiling point of silane coupling agents varies depending on the chemical structure, but is generally in a range of 100°C to 250°C. However, heating at 200°C or more is not preferable since a side reaction on the organic group side of silane coupling agent may be caused.

The environment for heating a silane coupling agent may be under any of raised pressure, normal pressure, or reduced pressure but is preferably under normal pressure or reduced pressure in the case of promoting the vaporization of the silane coupling agent. Since a large number of silane coupling agents are flammable liquids, it is preferable to perform the vaporization work in a closed container, preferably after purging the interior of the container with an inert gas.

The time for exposing the inorganic substrate to a silane coupling agent is not particularly limited, but is preferably within 20 hours, more preferably within 60 minutes, still more preferably within 15 minutes, most preferably within 10 minutes.

The temperature of the inorganic substrate during exposure of the inorganic substrate to a silane coupling agent is preferably controlled to an appropriate temperature between -50°C and 200°C depending on the kind of silane coupling agent and the desired thickness of the silane coupling agent layer.

The film thickness of the silane coupling agent layer is extremely thinner compared to those of the inorganic substrate, polymer film and the like, and the thickness between the highest portion of the inorganic substrate and the surface of the polymer film is negligible from the viewpoint of mechanical design. In principle, the film thickness is only required to be a thickness in the monomolecular layer order minimum. However, the film thickness is required to be thick in effect since it is necessary to fill the rough surface. In other words, the silane coupling agent is required in an amount approximately equal to the volume of the rough surface of the inorganic substrate. It is often difficult to measure the film thickness since the silane coupling agent is present as a significantly thin layer on the rough surface. The film thickness of the silane coupling agent layer is generally less than 20 nm from the upper end of the inorganic substrate, preferably 15 nm or less, and practically is preferably 10 nm or less, more preferably 7 nm or less, still more preferably 5 nm or less. However, it is not desirable that the silane coupling agent layer is present as a cluster rather than as a uniform coating film since the bonding area of the inorganic substrate with the polymer film decreases. The film thickness of the silane coupling agent layer can be calculated from the concentration and applied amount of the silane coupling agent solution at the time of application.

In the laminate of the present invention, it is required that an inorganic substrate, an amino group-containing silane coupling agent layer, and a heat resistant polymer film are laminated in this order and the nitrogen element ratio on the peeled surface of the inorganic substrate is more than 3.5 at% after the heat resistant polymer film has been peeled off from the inorganic substrate at 90°. The nitrogen element ratio is preferably 4 at% or more, still more preferably 5 at% or more. The nitrogen element ratio is 11 at% or less. The nitrogen element ratio is preferably 9 at% or less, still more preferably 8 at% or less. When the nitrogen element ratio is within the above range, the adhesive strength between the heat resistant polymer film and the inorganic substrate can be uniformly and appropriately controlled. Generation of bubbles between the inorganic substrate and the polymer film is prevented.

In the laminate of the present invention, it is preferable that the blister defect density is 5 spots or less per 1 square meter. The blister defect density is more preferably 4 spots or less, still more preferably 3 spots or less. The lower limit is not particularly limited, but industrially the blister defect density may be 1 spot or more. When the blister defect density is within the above range, a high-quality laminate can be obtained.

The laminate can be obtained by a lamination method in which
[method A]

(1) a step of coating at least one surface of an inorganic substrate with a silane coupling agent containing an amino group;
(2) a step of supplying an aqueous medium to a silane coupling agent-coated surface of the inorganic substrate and/or a bonding surface side of a heat resistant polymer film;
(3) a step of stacking the silane coupling agent-coated surface of the inorganic substrate and the heat resistant polymer film; and
(4) a step of pressurizing the inorganic substrate and the heat resistant polymer film while extruding the aqueous medium from between the silane coupling agent-coated surface of the inorganic substrate and the bonding surface of the heat resistant polymer film

are carried out preferably in this order.

In addition, in the present invention, the laminate can be obtained by a lamination method in which
[method B]

(1) a step of coating at least one surface of a heat resistant polymer film with a silane coupling agent containing an amino group;
(2) a step of supplying an aqueous medium to a bonding surface side of an inorganic substrate and/or a silane coupling agent-coated surface of the heat resistant polymer film;
(3) a step of stacking the inorganic substrate and the silane coupling agent-coated surface of the heat resistant polymer film; and
(4) a step of pressurizing the inorganic substrate and the heat resistant polymer film while extruding the aqueous medium from between the bonding surface of the inorganic substrate and the silane coupling agent-coated surface of the heat resistant polymer film

are carried out preferably in this order.

As the aqueous medium here, water or a mixed medium of water and a water-soluble solvent can be used. As the water-soluble solvent, lower alcohols, low-molecular-weight ketones, tetrahydrofuran, and the like can be used. Aqueous mediums preferably used are pure water, a mixed solvent of water and methanol, a mixed solvent of water and ethanol, a mixed solvent of water, isopropanol, and methyl ethyl ketone, a mixed solvent of water and tetrahydrofuran, and the like. Aqueous mediums particularly preferably used in the present invention are water; monohydric alcohols, dihydric alcohols, and trihydric alcohols, which are liquid at room temperature; or mixtures containing two or more components among these. A trace amount of surfactant may be added to the aqueous medium in order to improve the wettability between the aqueous medium and the inorganic substrate or polymer film.

As the method for wetting the bonding surface of the substrate or film with an aqueous medium, existing methods can be applied, such as dropping with a dropper or dispenser, discharging from a valve, or spraying from a spray nozzle in the form of mist. Immersing the substrate or film in an aqueous medium is also an effective means for wetting.

In the case of using a liquid containing water or an alcohol as the aqueous medium, the liquid also contributes to the promotion of the reaction of silane coupling agent.

As a method for bonding the inorganic substrate and the heat resistant polymer film to each other, a pressing method, a roll lamination method, and the like can be adopted. For example, pressurization can be performed in a planar or linear manner by pressing, lamination, or roll lamination in an atmosphere at the atmospheric pressure or in a vacuum. The process can also be promoted by performing heating during pressurization. In the present invention, pressing or roll lamination in the atmospheric air atmosphere is preferable, and particularly a method using a roll (roll lamination or the like) is preferable since bonding can be performed while sequentially extruding the aqueous medium at the bonding interface from the bonding surface.

The pressure at the time of pressurization (pressurization treatment) is preferably 0.1 MPa to 20 MPa, still more preferably 0.2 MPa to 3 MPa. When the pressure is 20 MPa or less, it is possible to suppress damage to the inorganic substrate. When the pressure is 0.1 MPa or more, it is possible to prevent the generation of a portion that is not in close contact and insufficient adhesion. It is also preferable to perform heating (pressurization and heating treatment) at the time of pressurization treatment. The temperature at the time of the pressurization and heating treatment is preferably 80°C to 400°C, more preferably 100°C to 200°C. The polymer film may be damaged when the temperature is too high, and the close contact force tends to be weak when the temperature is too low.

Although the pressurization and heating treatment can be performed in an atmosphere at the atmospheric pressure as described above, it may be possible to obtain uniform adhesive force by performing the pressurization and heating treatment in a vacuum. As the degree of vacuum, a degree of vacuum obtained by an ordinary oil-sealed rotary pump, namely, about 10 Torr or less is sufficient.

As a device that can be used for the pressurization and heating treatment, for example, an "11FD" manufactured by Imoto Machinery Co., Ltd. or the like can be used for performing pressing in a vacuum. For example, "MVLP" manufactured by MEIKI CO., LTD. or the like can be used for performing vacuum lamination using a roll-type film laminator in a vacuum or a film laminator for evacuating the air and then applying pressure at once to the entire surface of glass by a thin rubber film.

The pressurization and heating treatment can be performed by being divided into a pressurization process and a heating process. In this case, a pressure (preferably about 0.2 MPa to 50 MPa) is first applied to the polymer film and the inorganic substrate at a relatively low temperature (for example, a temperature of less than 120°C, more preferably 80°C or more and 110°C or less) to secure the close contact with each other, and then, the polymer film and the inorganic substrate are heated at a pressure (preferably 20 MPa or less and 0.2 MPa or more) or normal pressure and a relatively high temperature (for example, 80°C or more, more preferably 100°C to 250°C, still more preferably 120°C to 220°C), whereby the chemical reaction at the close contact interface can be promoted and the polymer film and the inorganic substrate can be laminated.

It is thus possible to obtain a laminate in which the inorganic substrate and the polymer film are bonded to each other.

However, the method for manufacturing a laminate according to the present invention is not limited to this example. As another example, the silane coupling agent layer is brought into contact with water at the time of lamination by dropping pure water on the heat resistant polymer film side, and the inorganic substrate is bonded to the heat resistant polymer film at almost the same time as the desired silane coupling agent layer is formed.

By dropping pure water on both the heat resistant polymer film side and the inorganic substrate, the reaction of the silane coupling agent is promoted and the desired bonding state is obtained. The inorganic substrate may be bonded to the heat resistant polymer film by such a method.

Consequently, as a preferred aspect of the laminate in the present invention, it is possible to obtain a laminate in which the 90-degree initial adhesive strength between the heat resistant polymer film and the inorganic substrate is 0.06 N/cm or more and 0.25 N/cm or less, the blister defect density is 5 spots or less per 1 square meter, preferably the area is 0.65 square meter or more, and the length of at least one side is 700 mm or more.

In the laminate, the adhesive strength (hereinafter also referred to as 90-degree initial adhesive strength) measured by the 90° peeling method is preferably 0.06 N/cm or more, more preferably 0.09 N/cm or more, still more preferably 0.1 N/cm or more when the heat resistant polymer film is peeled from the laminate. The 90-degree initial adhesive strength is preferably 0.25 N/cm or less, more preferably 0.2 N/cm or less. When the 90-degree initial adhesive strength is 0.06 N/cm or more, it is possible to prevent the heat resistant polymer film from peeling off from the inorganic substrate before and during device formation. When the 90-degree initial adhesive strength is 0.25 N/cm or less, the inorganic substrate and the heat resistant polymer film are easily peeled off from each other after device formation. In other words, when the 90-degree initial adhesive strength is 0.25 N/cm or less, the inorganic substrate and the heat resistant polymer film are easily peeled off from each other even if the adhesive strength therebetween slightly increases during device formation.

In the present specification, the 90-degree initial adhesive strength refers to the 90-degree adhesive strength between the inorganic substrate and the heat resistant polymer film after the laminate has been subjected to a heat treatment at 200°C for 1 hour in the air atmosphere.

The measurement conditions of the 90-degree initial adhesive strength are as follows.

The heat resistant polymer film is peeled off from the inorganic substrate at an angle of 90 degrees.

The measurement is performed 5 times and the average value thereof is taken as the measured value.

Measured temperature: Room temperature (25°C)
Peeling speed: 100 mm/min
Atmosphere: Air
Width of measured sample: 2.5 cm

More specifically, the method described in Examples is adopted.

In the present specification, it is preferable that the adhesive strength after heat treatment is also within the above range in addition to the initial adhesive strength. The adhesive strength after heat treatment refers to the 90-degree adhesive strength between the inorganic substrate and the heat resistant polymer film after the laminate has been subjected to a heat treatment at 200°C for 1 hour in the air atmosphere and then to a heat treatment at 450°C for 1 hour.

In the present specification, the "adhesive strength" means both "initial adhesive strength" and "adhesive strength after heat treatment". In other words, the "adhesive strength of 0.06 N/cm or more and 0.25 N/cm or less" means that the "initial adhesive strength is 0.06 N/cm or more and 0.25 N/cm or less" and the "adhesive strength after heat treatment is 0.06 N/cm or more and 0.25 N/cm or less".

In the present invention, a functional element is formed on the surface on the opposite side to the bonding surface of the heat resistant polymer film of the laminate obtained by the method A or method B, and the heat resistant polymer film is peeled off from the inorganic substrate together with the functional element after formation, whereby a flexible electronic device can be fabricated.

In the present specification, the electronic device refers to a wiring board which carries out electrical wiring and has a single-sided, double-sided, or multi-layered structure, electronic circuits including active devices such as transistors and diodes and passive devices such as resistors, capacitors, and inductors, sensor elements which sense pressure, temperature, light, humidity and the like, biosensor elements, light emitting elements, image display elements such as liquid crystal displays, electrophoresis displays, and self-luminous displays, wireless and wired communication elements, arithmetic elements, storage elements, MEMS elements, solar cells, thin film transistors, and the like.

In the method for manufacturing a flexible electronic device in the present specification, an electronic device is formed on the polymer film surface of a laminate fabricated by the above-described method and then the polymer film is peeled off from the inorganic substrate.

The method for peeling off the polymer film, on which an electronic device is formed, from the inorganic substrate is not particularly limited, but a method in which the polymer film is stripped off from the end with tweezers and the like, a method in which a cut is made into the polymer film, a pressure sensitive adhesive tape is pasted to one side of the cut portion, and then the polymer film is stripped off from the tape portion, a method in which one side of the cut portion of the polymer film is vacuum-adsorbed and then the polymer film is stripped off from that portion, and the like can be adopted. When the cut portion of the polymer film is bent with a small curvature during peeling off, stress may be applied to the device at that portion and the device may be destroyed, and it is thus desirable to peel off the polymer film in the state of having a curvature as large as possible. For example, it is desirable to strip off the polymer film while winding the polymer film on a roll having a large curvature or to strip off the polymer film using a machine having a configuration in which the roll having a large curvature is located at the peeling portion.

As the method for making a cut into the polymer film, there are a method in which the polymer film is cut with a cutting tool such as a cutter, a method in which the polymer film is cut by scanning a laser and the laminate relative to each other, a method in which the polymer film is cut by scanning a water jet and the laminate relative to each other, a method in which the polymer film is cut while being cut a little to the glass layer by a dicing apparatus for a semiconductor chip, and the like, but the method is not particularly limited. For example, when employing the above-described methods, it is also possible to appropriately employ a technique in which ultrasonic waves are superimposed on the cutting tool or a reciprocating motion, a vertical motion and the like are further added to improve the cutting performance.

It is also useful to stick another reinforcing base material to the portion to be peeled off in advance and peel off the polymer film together with the reinforcing base material. In a case where the flexible electronic device to be peeled off is the backplane of a display device, it is also possible to obtain a flexible display device by sticking the front plane of the display device in advance, integrating these on an inorganic substrate, and then peeling off these two at the same time.

EXAMPLES

Hereinafter, the present invention will be described in detail with reference to Examples, but the present invention is not limited to the following Examples as long as the gist of the present invention is not exceeded.

Unless otherwise stated, the respective measured values in Examples and Comparative Examples were measured by the following methods.

<Thickness of heat resistant polymer film>

The thickness of the heat resistant polymer film was measured using a micrometer (Millitron 1245D manufactured by Feinpruf GmbH).

<Tensile elasticity, tensile breaking strength, and tensile breaking elongation of heat resistant polymer film>

The heat resistant polymer film was cut into a strip shape of 100 mm $\times$ 10 mm respectively in the machine direction (MD direction) and the transverse direction (TD direction), thereby obtaining a test piece. The test piece was cut from the center portion in the transverse direction. The tensile elasticity, tensile breaking strength, and tensile breaking elongation in each of the MD direction and the TD direction were measured at a temperature of 25°C, a tensile speed of 50 mm/min, and a distance between chucks of 40 mm using a tensile tester (Autograph (R), Model name: AG-5000A manufactured by Shimadzu Corporation).

<Coefficient of linear thermal expansion (CTE)>

The expansion/contraction rate of the polymer film in the machine direction (MD direction) and the transverse direction (TD direction) was measured under the following conditions, the expansion/contraction rate/temperature was measured at intervals of 15°C, such as 30°C to 45°C and 45°C to 60°C, this measurement was performed up to 300°C, and the average value of all measured values was calculated as CTE.

Instrument name: TMA4000S manufactured by MAC Science Corporation
Length of sample: 20 mm
Width of sample: 2 mm
Start temperature in temperature increase: 25°C
End temperature in temperature increase: 400°C
Rate of temperature increase: 5°C/min
Atmosphere: Argon

<Measurement of adhesive strength>

The adhesive strength of the polymer film from the laminate obtained in the laminate fabrication by the 90-degree peeling method was determined by the following method.
The film is peeled off from the inorganic substrate at an angle of 90 degrees.

Measuring instrument: Autograph AG-IS manufactured by Shimadzu Corporation
Measured temperature: Room temperature (25°C)
Peeling speed: 100 mm/min
Atmosphere: Air
Width of measured sample: 2.5 cm

The measurement was performed on a total of 5 points of the center portion and four corners of the laminate, and the average value thereof was determined.

<Counting of blister defects>

In the present invention, those having a long diameter of 300 $\mu$m or more were counted as blisters. Blisters are also called float defects or bubble defects, are spots where the film floats like a bubble but is not bonded to the substrate, and are often generated as the film is lifted like a tent by sandwiching a relatively hard foreign matter.
In the present Example, the laminate was magnified and observed by focusing on the bonding surface between the inorganic substrate and the polymer film, and the number of blisters having a long diameter of 300 um or more was counted for at least

4 sheets of laminates having a G2 (370 mm × 470 mm) size,
2 sheets of laminates having a G4.5 (730 mm × 920 mm) size, and
1 sheet of laminate having a G5 (1100 mm × 1250 mm) size, and

converted to the number per 1 square meter.

<Elemental nitrogen component ratio>

The peeled surface obtained by peeling off the polymer film from the laminate at 90° was analyzed in a range of 50 mm × 50 mm by ESCA, and the proportion of nitrogen element present on the peeled surface of the inorganic substrate was evaluated. K-Alpha⁺ (manufactured by Thermo Fisher Scientific) was used as the instrument. The measurement conditions are as follows. At the time of analysis, the background was removed by the shirley method. The surface composition ratio was the average value of the measurement results at three or more places.

·Measurement conditions

Excited X-rays: Monochrome Al Kα rays
X-ray output: 12 kV, 6 mA
Photoelectron escape angle: 90°
Spot size: 400 pmp
Path energy: 50 eV
Step: 0.1 eV

<Surface roughness Ra of inorganic substrate>

Ra was measured using a confocal microscope (HYBRID C3 manufactured by Lasertec Corporation). The measurement was performed using a 50× objective lens at a scan resolution of 0.06 $\mu$m in a color channel of blue mode.
As the measurement (observation) range, observation was performed in a square region of about 300 $\mu$m in both X and Y. For the SUS substrate, the edges were kept out of the measurement range, but it was confirmed that the value of Ra did not change particularly depending on the position any more, and then the measurement was performed without particularly determining the position.

[Preparation of polyamic acid solution A]

The interior of a reaction vessel equipped with a nitrogen inlet tube, a thermometer, and a stirring rod was purged with nitrogen, and then 223 parts by mass of 5-amino-2-(p-aminophenyl)benzoxazole (DAMBO) and 4416 parts by mass of N,N-dimethylacetamide were added into the reaction vessel and completely dissolved. Next, SNOWTEX (DMAC-ST30, manufactured by Nissan Chemical Corporation) in which colloidal silica (average particle size: 0.08 $\mu$m) was dispersed in dimethylacetamide was added to the solution together with 217 parts by mass of pyromellitic dianhydride (PMDA) so that colloidal silica was 0.7% by mass with respect to the total amount of polymer solids in the polyamic acid solution A, and the mixture was stirred at a reaction temperature of 25°C for 24 hours, thereby obtaining a brown and viscous polyamic acid solution A.

[Fabrication Example 1 of polyimide film]

The polyamic acid solution A was applied (coating width: 1240 mm) to a mirror-finished endless continuous belt made of stainless steel using a die coater, and dried at 90°C to 115°C for 10 minutes. The polyamic acid film which was self-supporting after drying was peeled off from the support and both ends thereof were cut, thereby obtaining a green film.
The obtained green film was transported by a pin tenter so that the final pin sheet interval was 1140 mm, and subjected to a heat treatment at 170°C for 2 minutes as the first stage, at 230°C for 2 minutes as the second stage, and at 465°C for 6 minutes as the third stage to conduct the imidization reaction. Thereafter, the film was cooled to room temperature for 2 minutes, the portions exhibiting poor flatness of both ends of the film were cut off using a slitter, and the film was then wound into a roll shape, thereby obtaining a polyimide film 1 presented in Table 1.

[Fabrication Example 2 of polyimide film]

A polyimide film 2 presented in Table 1 was obtained by performing the operation in the same manner except that the gap of the die coater was changed so that the finished polyimide film thickness was 38 $\mu$m.

[Polyimide film 3]

A 25 $\mu$m-thick polyimide film Upilex 25S (registered trademark) manufactured by UBE INDUSTRIES, LTD. was used as a polyimide film 3.

fabrication of laminate>

(Example 1)

First, the polyimide film 1 obtained in Fabrication Example 1 was cut to have 370 mm $\times$ 500 mm width. Next, UV/O$_3$ irradiation was performed for 3 minutes using a UV/O$_3$ irradiator (SKR1102N-03 manufactured by LANTECHNICAL SERVICE CO., LTD.) as a film surface treatment. At this time, the distance between the UV/O$_3$ lamp and the film was set to 30 mm.

An inorganic substrate having a G2 size (370 mm $\times$ 470 mm, 0.7 mm thick SUS substrate) was coated with an amino group-containing silane coupling agent via the gas phase using the apparatus of which the schematic diagram was illustrated in Fig. 1.

The inorganic substrate used was washed with pure water, dried, and then irradiated using a UV/O$_3$ irradiator (SKR1102N-03 manufactured by LANTECHNICAL SERVICE CO., LTD.) for 1 minute for dry cleaning.

The inorganic substrate was placed in the chamber of the apparatus, and 130 g of 3-aminopropyltrimethoxysilane (KBM-903 manufactured by Shin-Etsu Chemical Co., Ltd.) was put into a chemical tank having a capacity of 1 L, the outer water bath of the chemical tank was warmed to 42°C, and the generated silane coupling agent vapor was sent to the chamber together with clean dry air at a gas flow rate of 22 L/min, and the inorganic substrate was exposed to this silane coupling agent vapor. At this time, the substrate temperature was set to 21°C, the clean dry air temperature was set to 23°C, and the humidity was set to 1.2% RH. Since the exhaust is connected to the exhaust port having a negative pressure, it is confirmed that the chamber has a negative pressure of about 10 Pa by a differential pressure gauge.

The inorganic substrate coated with an amino group-containing silane coupling agent in this manner was set in a roll laminator equipped with a silicon rubber roller. First, 100 ml of pure water as an aqueous medium was dropped onto the silane coupling agent-coated surface using a dropper so as to spread over the entire substrate, thereby wetting the substrate.

Next, the treated surface of the polyimide film was stacked on the inorganic substrate so as to face the silane coupling agent-coated surface of the inorganic substrate, namely, the surface wetted with pure water, and the stacked body was pressurized while extruding pure water between the polyimide film and the inorganic substrate using a rotating roll sequentially from one side of the inorganic substrate to laminate the inorganic substrate and the polyimide film, thereby obtaining a temporary laminate. The laminator used was a laminator having an effective roll width of 1350 mm (manufactured by MCK CO., LTD.), and the bonding conditions were: air source pressure: 0.5 MPa, laminating speed: 50 mm/sec, roll temperature: 22°C, environmental temperature: 22°C, and humidity: 55% RH.

The obtained temporary laminate was subjected to a heat treatment at 200°C for 10 minutes in a clean oven to obtain the laminate according to the present invention. Similar operation was performed on four inorganic substrates.

The evaluation results of the obtained laminates are presented in Table 2.

(Examples 2 to 20 and Comparative Examples 1 to 4)

The laminates were fabricated in the same manner under the conditions presented in Tables 2 to 5, and the properties of the laminates were evaluated. The results are presented in Tables 2 to 5. As the films, inorganic substrates, and aqueous media in the tables, the following ones were used. Note 1 in the tables indicates that the peeled surface could not be defined and the elemental nitrogen component ratio could not be measured since the film and the inorganic substrate did not bond to each other.

Film 1: Polyimide film obtained in Fabrication Example 1 of polyimide film
Film 2: Polyimide film obtained in Fabrication Example 2 of polyimide film
Film 3: Polyimide film Upilex25S (registered trademark) manufactured by UBE INDUSTRIES, LTD.

Glass: OA10G manufactured by Nippon Electric Glass Co., Ltd.

The size of the inorganic substrate is as follows, and SUS substrate (surface roughness Ra is 45 nm), steel (carbon steel) substrate (surface roughness Ra is 35 nm), Cu substrate (surface roughness Ra is 14 nm) and glass substrate (surface roughness Ra is 0.6 nm) all have the same size.

G2 size (370 mm × 470 mm)

G4.5 size (730 mm × 920 mm)

G5 size (1100 mm × 1250 mm)

Aqueous medium

Pure water: Ultrapure water

Pure water + MeOH: Pure water 99/Methanol 1 (mass ratio)

Pure water + EtOH: Pure water 99/Ethanol 1 (mass ratio)

[Table 1]

| Film No. | | | 1 | 2 | 3 |
|---|---|---|---|---|---|
| | | | Fabrication Example 1 | Fabrication Example 2 | Ube Industries Upilex 25S |
| Thickness | | μm | 12.5 | 38.0 | 25.0 |
| Film width | | mm | 1160 | 1160 | 500 |
| Tensile breaking strength | MD | MPa | 446.0 | 428.0 | 515.0 |
| | TD | | 438.0 | 435.0 | 520.0 |
| Tensile elasticity | MD | GPa | 7.3 | 7.7 | 9.0 |
| | TD | | 7.2 | 7.2 | 9.1 |
| Tensile breaking elongation | MD | % | 32.9 | 32.8 | 38.5 |
| | TD | | 35.3 | 34.7 | 41.0 |
| Coefficient of linear thermal expansion (CTE) | MD | ppm/°C | 2.3 | 2.1 | 15.4 |
| | TD | | 2.7 | 2.6 | 16.8 |

[Table 2]

| | Example 1 | Example 2 | Example 3 | Example 4 | Example 5 | Example 6 |
|---|---|---|---|---|---|---|
| Film | Film 1 | Film 1 | Film 1 | Film 2 | Film 2 | Film 2 |
| Inorganic substrate | SUS | SUS | SUS | SUS | Steel (carbon steel) | Steel (carbon steel) |
| Inorganic substrate size | G2 | G2 | G2 | G2 | G2 | G2 |
| Film surface treatment | UV/O$_3$ | UV/O$_3$ | Atmospheric pressure plasma | UV/O$_3$ | Atmospheric pressure plasma | UV/O$_3$ |

(continued)

| | Example 1 | Example 2 | Example 3 | Example 4 | Example 5 | Example 6 |
|---|---|---|---|---|---|---|
| SCA coating | Inorganic substrate side | Inorganic substrate side | Inorganic substrate side | Inorganic substrate side | Inorganic substrate side | Inorganic substrate side |
| SCA coating time (min) | 3.0 | 7.0 | 2.0 | 2.0 | 3.0 | 3.0 |
| Aqueous medium | Pure water | Pure water | Pure water | Pure water | Pure water | Pure water |
| Initial adhesive strength (N/cm) | 0.09 | 0.08 | 0.11 | 0.12 | 0.10 | 0.12 |
| Adhesive strength after heat treatment (N/cm) | 0.13 | 0.13 | 0.08 | 0.12 | 0.11 | 0.14 |
| Blister density (spots/ square meter) | 7.2 | 11.5 | 7.2 | 5.8 | 7.2 | 11.5 |
| Elemental nitrogen component ratio on peeled surface of inorganic substrate (element%) | 9.56 | 3.55 | 5.29 | 10.6 | 6.70 | 4.12 |

[Table 3]

| | Example 7 | Example 8 | Example 9 | Example 10 | Example 11 | Example 12 |
|---|---|---|---|---|---|---|
| Film | Film 1 | Film 1 | Film 1 | Film 2 | Film 2 | Film 3 |
| Inorganic substrate | Cu | CU | Cu | CU | CU | CU |
| Inorganic substrate size | G2 | G2 | G2 | G2 | G2 | G2 |
| Film surface treatment | UV/$O_3$ | UV/$O_3$ | Atmospheric pressure plasma | UV/$O_3$ | Atmospheric pressure plasma | UV/$O_3$ |
| SCA coating | Inorganic substrate side | Inorganic substrate side | Inorganic substrate side | Inorganic substrate side | Inorganic substrate side | Inorganic substrate side |
| SCA coating time (min) | 5.0 | 10.0 | 5.0 | 5.0 | 5.0 | 10.0 |
| Aqueous medium | Pure water | Pure water | Pure water | Pure water | Pure water | Pure water |
| Initial adhesive strength (N/cm) | 0.16 | 0.11 | 0.13 | 0.13 | 0.07 | 0.12 |
| Adhesive strength after heat treatment (N/cm) | 0.13 | 0.15 | 0.15 | 0.13 | 0.12 | 0.12 |
| Blister density (spots/ square meter) | 7.2 | 5.8 | 10.1 | 7.2 | 8.6 | 10.1 |
| Elemental nitrogen component ratio on peeled surface of inorganic substrate (element%) | 7.67 | 9.49 | 6.54 | 4.89 | 4.84 | 3.01 |

[Table 4]

|  | Example 13 | Example 14 | Comparative Example 1 | Comparative Example 2 | Comparative Example 3 | Comparative Example 4 |
|---|---|---|---|---|---|---|
| Film | Film 1 | Film 1 | Film 1 | Film 1 | Film 2 | Film 3 |
| Inorganic substrate | Glass | Glass | SUS | SUS | Steel (carbon steel) | Cu |
| Inorganic substrate size | G2 | G2 | G2 | G2 | G2 | G2 |
| Film surface treatment | UV/O$_3$ | UV/O$_3$ | Atmospheric pressure plasma | UV/O$_3$ | Atmospheric pressure plasma | UV/O$_3$ |
| SCA coating | Film side | Film side | Inorganic substrate side | Inorganic substrate side | Inorganic substrate side | Inorganic substrate side |
| SCA coating time (min) | 3.0 | 7.0 | 3.0 | 10.0 | 3.0 | 30.0 |
| Aqueous medium | Pure water | Pure water | Absence | Absence | Absence | Absence |
| Initial adhesive strength (N/cm) | 0.09 | 0.08 | - | - | - | 0.33 |
| Adhesive strength after heat treatment (N/cm) | 0.17 | 0.13 | - | - | - | 0.68 |
| Blister density (spots/ square meter) | 5.8 | 10.1 | - | - | - | 20.2 |
| Elemental nitrogen component ratio on peeled surface of inorganic substrate (element%) | 8.70 | 4.52 | Note 1 | Note 1 | Note 1 | 24.70 |

[Table 5]

|  | Example 15 | Example 16 | Example 17 | Example 18 | Example 19 | Example 20 |
|---|---|---|---|---|---|---|
| Film | Film 2 | Film 2 | Film 1 | Film 2 | Film 1 | Film 2 |
| Inorganic substrate | SUS | SUS | SUS | SUS | SUS | SUS |
| Inorganic substrate size | G4.5 | G4.5 | G5 | G5 | G5 | G5 |
| Film surface treatment | UV/O$_3$ | UV/O$_3$ | UV/O$_3$ | UV/O$_3$ | UV/O$_3$ | UV/O$_3$ |
| SCA coating | Inorganic substrate side | Film side | Inorganic substrate side | Inorganic substrate side | Film side | Film side |
| SCA coating time (min) | 5.0 | 5.0 | 5.0 | 5.0 | 5.0 | 5.0 |
| Aqueous medium | Pure water | Water + EtOH | Pure water | Pure water | Pure water + MeOH | Pure water + EtOH |
| Initial adhesive strength (N/cm) | 0.11 | 0.11 | 0.10 | 0.14 | 0.11 | 0.08 |

(continued)

|  | Example 15 | Example 16 | Example 17 | Example 18 | Example 19 | Example 20 |
|---|---|---|---|---|---|---|
| Adhesive strength after heat treatment (N/cm) | 0.11 | 0.15 | 0.12 | 0.14 | 0.13 | 0.10 |
| Blister density (spots/square meter) | 5.8 | 10.1 | 7.2 | 5.8 | 5.8 | 11.5 |
| Elemental nitrogen component ratio on peeled surface of inorganic substrate (element%) | 3.82 | 9.43 | 6.33 | 10.04 | 5.03 | 8.86 |

<Application Example (Fabrication of flexible electronic device)>

The following steps were performed using the laminate obtained in Example 15, whereby a tungsten film (thickness: 75 nm) was formed on the polyimide film by a vacuum vapor-deposition method and further a silicon oxide film (thickness: 150 nm) as an insulating film was laminated and formed thereon without touching the atmospheric air. Next, a silicon oxide nitride film (thickness: 100 nm) to be the ground insulating film was formed by the plasma CVD method, and further an amorphous silicon film (thickness: 54 nm) was laminated and formed without touching the atmospheric air.

Next, the hydrogen element of the amorphous silicon film was eliminated to promote crystallization, and a heat treatment at 500°C was performed for 40 minutes to form a polysilicon film.

A TFT device was fabricated using the obtained polysilicon film. First, patterning of the polysilicon thin film was performed to form a silicon region having a predetermined shape, as appropriate, a gate insulating film was formed, a gate electrode was formed, a source region or a drain region was formed by doping the active region, the interlayer insulating film was formed, the source electrode and drain electrode were formed, and the activation treatment was performed, thereby fabricating a P-channel TFT array using polysilicon.

The polymer film portion was burned off by a UV-YAG laser along about 0.5 mm inner side of the TFT array periphery, and the polymer film was peeled off from the end of the cut using a thin razor-shaped blade so as to scoop up, thereby obtaining a flexible A3 size TFT array. The peel angle at this time is 3 degrees. The peeling was possible by extremely weak force, and it was possible to peel off the TFT array without damaging the TFT. The obtained flexible TFT array did not show any deterioration in performance even when wound around a 3 mmφ round bar, and maintained favorable properties.

INDUSTRIAL APPLICABILITY

As described above, the method for manufacturing a laminate and the laminate obtained by the method of the present invention can stably realize low adhesive strength without unevenness in the case of a large area as well, the generation frequency of blister defects is extremely low, and thus the laminate is extremely useful as a temporary support substrate for manufacturing a flexible device having high quality and a large area.

DESCRIPTION OF REFERENCE SIGNS

1　Flow meter
2　Gas inlet
3　Chemical tank (silane coupling agent tank)
4　Hot water tank (water bath)
5　Heater
6　Processing chamber (chamber)
7　Substrate to be coated
8　Exhaust port

**Claims**

1. A laminate comprising an inorganic substrate, a layer of a silane coupling agent containing an amino group, and a heat resistant polymer film in this order, wherein an elemental nitrogen component ratio on a peeled surface on an inorganic substrate side is more than 3.5 at% and 11 at% or less after the heat resistant polymer film has been peeled off from the inorganic substrate at 90°.

2. The laminate according to claim 1, wherein an adhesive strength by a 90° peeling method when the heat resistant polymer film is peeled off from the laminate is 0.06 N/cm or more and 0.25 N/cm or less.

3. The laminate according to claim 1 or 2, wherein a surface roughness Ra of the inorganic substrate is 1 nm or more and 1000 nm or less.

4. The laminate according to any one of claims 1 to 3, wherein the heat resistant polymer film is a polyimide film.

5. The laminate according to any one of claims 1 to 4, wherein a blister defect density is 12 spots or less per 1 square meter.

6. The laminate according to any one of claims 1 to 5, wherein the laminate is rectangular, has an area of 0.65 square meter or more, and has a rectangular side of at least 700 mm or more.

7. A method for manufacturing a laminate including an inorganic substrate, a layer of a silane coupling agent containing an amino group, and a heat resistant polymer film in this order, the method comprising at least:

    (1) a step of coating at least one surface of an inorganic substrate with a silane coupling agent containing an amino group;
    (2) a step of supplying an aqueous medium to a silane coupling agent-coated surface of the inorganic substrate and/or a bonding surface side of a heat resistant polymer film;
    (3) a step of stacking the silane coupling agent-coated surface of the inorganic substrate and the heat resistant polymer film; and
    (4) a step of pressurizing the inorganic substrate and the heat resistant polymer film while extruding the aqueous medium from between the silane coupling agent-coated surface of the inorganic substrate and the bonding surface of the heat resistant polymer film.

8. A method for manufacturing a laminate including an inorganic substrate, a layer of a silane coupling agent containing an amino group, and a heat resistant polymer film in this order, the method comprising at least:

    (1) a step of coating at least one surface of a heat resistant polymer film with a silane coupling agent containing an amino group;
    (2) a step of supplying an aqueous medium to a bonding surface side of an inorganic substrate and/or a silane coupling agent-coated surface of the heat resistant polymer film;
    (3) a step of stacking the inorganic substrate and the silane coupling agent-coated surface of the heat resistant polymer film; and
    (4) a step of pressurizing the inorganic substrate and the heat resistant polymer film while extruding the aqueous medium from between the bonding surface of the inorganic substrate and the silane coupling agent-coated surface of the heat resistant polymer film.

9. A method for manufacturing a flexible electronic device, the method comprising a step of forming a functional element on a surface on an opposite side to a bonding surface of a heat resistant polymer film with an inorganic substrate of a laminate obtained by the manufacturing method according to claim 7 or 8.

Fig.1

**INTERNATIONAL SEARCH REPORT**

| International application No. |
|---|
| **PCT/JP2021/028448** |

**A.    CLASSIFICATION OF SUBJECT MATTER**

*B32B 9/00*(2006.01)i; *B32B 27/34*(2006.01)i; *H01L 21/02*(2006.01)i; *B29C 65/48*(2006.01)i
FI:    B32B9/00 A; B32B27/34; B29C65/48; H01L21/02 B; H01L21/02 C

According to International Patent Classification (IPC) or to both national classification and IPC

**B.    FIELDS SEARCHED**

Minimum documentation searched (classification system followed by classification symbols)
B32B1/00-43/00; H01L21/02; B29C65/48

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | JP 2020-59226 A (TOYOBO CO., LTD.) 16 April 2020 (2020-04-16) | 1-4, 6 |
|  | claims, paragraphs [0001], [0005], [0066], examples, for examples, table 2-4 |  |
| A | entire text | 5, 7-9 |
| A | JP 2011-63760 A (SEIKO EPSON CORP.) 31 March 2011 (2011-03-31) | 1-9 |
|  | entire text |  |
| P, X | JP 2020-203961 A (TOYOBO CO., LTD.) 24 December 2020 (2020-12-24) | 1-6 |
|  | examples |  |
| P, X | WO 2021/065101 A1 (TOYOBO CO., LTD.) 08 April 2021 (2021-04-08) | 1-9 |
|  | for example, examples |  |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 October 2021** | **26 October 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2021/028448**

| Patent document cited in search report | | | Publication date (day/month/year) | Patent family member(s) | Publication date (day/month/year) |
|---|---|---|---|---|---|
| JP | 2020-59226 | A | 16 April 2020 | (Family: none) | |
| JP | 2011-63760 | A | 31 March 2011 | (Family: none) | |
| JP | 2020-203961 | A | 24 December 2020 | (Family: none) | |
| WO | 2021/065101 | A1 | 08 April 2021 | (Family: none) | |

Form PCT/ISA/210 (patent family annex) (January 2015)

**REFERENCES CITED IN THE DESCRIPTION**

**Patent documents cited in the description**

- JP 5152104 B
- JP 5304490 B
- JP 5531781 B